# FASCICULE DE BREVET EUROPEEN

(11) **EP 0 338 945 B1**
(45) Date de publication et mention de la délivrance du brevet: **11.08.1993**
(21) Numéro de dépôt: 89420121.9
(22) Date de dépôt: 04.04.1989
(51) Int. Cl.: H02M 1/08

(54) **Dispositif statique à thyristors pour un réseau alternatif à moyenne tension**
Statische Thyristoreinrichtung für ein Mittelspannungswechselstromnetz
Static thyristor-arrangement for a middle-range voltage AC network

(30) Priorité: 22.04.1988 FR 8805490
(43) Date de publication de la demande: 25.10.1989
(73) Titulaire: MERLIN GERIN, F-38240 Meylan (FR)
(72) Inventeur: Vaillant, Frédéric, F-38050 Grenoble cedex (FR); Barrault, Michel, F-38050 Grenoble cedex (FR)
(74) Mandataire: Hecké, Gérard

(56) Documents cités:
- FR-A- 2 527 023
- US-A- 3 376 523
- US-A- 3 593 038
- US-A- 3 593 039
- US-A- 3 596 168
- HEUMANN/STUMPE"Thristoren" 3ième edition,3ième partie "Stromrichter ohne Kommutierung"1974,B.G. TEUBNER,Stuttgart pages 58-82

## Description

L'invention est relative à un dispositif statique pour un réseau alternatif à moyenne tension, notamment un contacteur, un disjoncteur ou un gradateur, comprenant dans chaque conducteur de phase, un module élémentaire ayant deux thyristors de puissance branchés en parallèle tête-bêche, et un dispositif d'amorçage pour le passage de l'état bloqué vers l'état conducteur des thyristors respectivement lors de l'ouverture et de la fermeture du dispositif , la gâchette de chaque thyristor étant associée à un dispositif individuel de commande comportant un transformateur possédant un enroulement primaire connecté à une source d'alimentation extérieure à courant alternatif ayant une fréquence supérieure à celle du réseau, et un enroulement secondaire coopérant avec un dispositif redresseur pour injecter en permanence un courant de commande dans ladite gâchette tant que le thyristor correspondant doit rester dans l'état conducteur,

Dans les contacteurs statiques de l'art antérieur, l'amorçage des thyristors tête-bêche d'un module s'effectue par injection d'un courant de commande dans le circuit gâchette-cathode de chaque thyristor. Un thyristor amorcé reste conducteur tant que le courant principal est supérieur au courant d'accrochage. L'ouverture du contacteur par blocage des thyristors s'opère automatiquement au zéro de courant en l'absence de réamorçage. Pour maintenir la fermeture du contacteur, le réamorçage des thyristors est indispensable à chaque passage naturel à zéro du courant alternatif circulant dans le conducteur de phase du réseau. Le passage à zéro du courant intervient à chaque demialternance, c'est-à-dire toutes les 10 millisecondes pour un réseau à 50 Hz. Ce réamorçage est généralement piloté par un transformateur d'impulsions destiné à délivrer une série d'impulsions à la gâchette des thyristors. Une impulsion doit être appliquée à la gâchette pour chaque réamorçage. Une telle méthode implique la synchronisation précise de l' envoi des impulsions d'amorçage avec les passages à zéro du courant pour maintenir les thyristors dans l'état conducteur.

Le document HEUMANN / STUMPE Thyristoren 3ème édition, 1974, B.G. TEUBNER, pages 58-82 divulgue l'alimentation du circuit de gâchette d'un thyristor par un courant de commande permanent issu d'une source d'alimentation à transformateur et redresseur. Le domaine d'application est néanmoins celui de la basse tension.

Le document US-A-3.376.523 décrit un dispositif destiné à supprimer des transitoires à haute fréquence entre les enroulements d'un transformateur à basse tension, utilisé dans le domaine électronique. Le circuit magnétique comporte deux culasses séparées l'une de l'autre par un écran réalisé en un matériau **magnétique**. La transmission de l'énergie du primaire vers le secondaire s'opère à travers l'écran. L'épaisseur de cet écran est choisie pour atténuer faiblement les basses fréquences (par exemple 50Hz ou 60Hz), et pour atténuer fortement les signaux à hautes fréquences. L'écran joue le rôle d'une fenêtre ou filtre supprimant les tensions transitoires dans une ligne de transmission magnétique.

Le problème posé dans un contacteur à thyristors à moyenne tension, est celui de l' isolement requis entre le conducteur de phase et la terre, étant donné que les thyristors se trouvent au potentiel de la ligne, et que la source de commande est par comparaison pratiquement à la masse. Le niveau d'isolement est déterminant pour le choix des thyristors d'un contacteur statique utilisé dans un réseau à moyenne tension, ayant par exemple une tension nominale de 7,2 kV. L'isolement phase-terre doit satisfaire à une tension de choc de 31 kV. A la coupure, les thyristors devraient supporter une tension de 15 kV entre entrée et sortie du module en l'absence de parasurtenseur. Les transformateurs d'impulsions du commerce ne sont pas adaptés au niveau d'isolement phase-terre requis dans un réseau à moyenne tension. La réalisation de tels transformateurs imposerait un surdimensionnement inacceptable avec l'encombrement et le coût de fabrication prohibitif. Une autre difficulté est la conception d'un système de synchronisation pouvant d'une part supporter des tensions de plusieurs kV lorsque les thyristors sont bloqués, et travaillent d'autre part à des tensions de quelques volts lorsque les thyristors sont passants, tout en étant immunisés contre les phénomènes parasites.

L'objet de l'invention consiste à réaliser un dispositif de commande simple et fiable pour les thyristors d'un contacteur statique à moyenne tension autorisant un bon isolement entre la ligne sous tension et la source de commande.

Le contacteur statique selon l'invention est caractérisé en ce que la source d'alimentation se trouve au potentiel de la masse, et qu'une plaque diélectrique est interposée entre l'enroulement primaire et l'enroulement secondaire du transformateur à isolement galvanique, ladite plaque en matériau isolant ayant une épaisseur prédéterminée pour la tension d'isolement requise entre le conducteur de phase du réseau et la source d'alimentation, et des moyens de répartition uniforme du champ électrique sur la plaque diélectrique.

L'isolement phase-terre est assuré par la plaque diélectrique du transformateur, insérée entre les enroulements primaire et secondaire. L'épaisseur de la plaque isolante détermine la tension d'isolement requise.

Le courant de commande du thyristor est un courant continu obtenu au moyen d'un condensateur de filtrage disposé à la sortie du dispositif redresseur, en parallèle entre la gâchette et la cathode du thyristor.

La source d'alimentation est pilotée par un circuit logique de contrôle pour l'établissement ou l'interruption du courant de commande dans la gâchette des thyristors du module provoquant respectivement le déblocage des thyristors lors de la fermeture du contacteur, et le blocage automatique des thyristors intervenant lors de l'ouverture du contacteur au premier passage à zéro du courant de ligne parcourant le conducteur de phase.

Le transformateur est associé à des condensateurs raccordés du côté primaire et/ou secondaire pour compenser les inductances de fuite, l'ensemble étant accordé à la fréquence de la source d'alimentation.

En fonction de la valeur de la tension du réseau à moyenne tension, une pluralité de modules élémentaires de thyristors tête-bêche sont connectés en série dans le conducteur de phase. Le réseau peut être monophasé ou triphasé.

Chaque module comporte un limiteur de surtension et un condensateur branchés chacun en parallèle aux bornes des thyristors, respectivement pour écrêter les surtensions transitoires, et pour contrôler la montée en tension des thyristors lors de l'ouverture du contacteur statique.

D'autres avantages et caractéristiques ressortiront plus clairement de la description qui va suivre d'un mode de réalisation de l'invention donné à titre d'exemple non limitatif et représenté aux dessins annexés, dans lesquels:
- la figure 1 montre le circuit électrique d'un contacteur statique à thyristors ayant deux modules en série par phase;
- la figure 2 représente une vue schématique en perspective d'un transformateur utilisé dans le dispositif de commande de chaque thyristor;
- la figure 3 montre le circuit électrique détaillé du dispositif de commande associé à chaque thyristor.

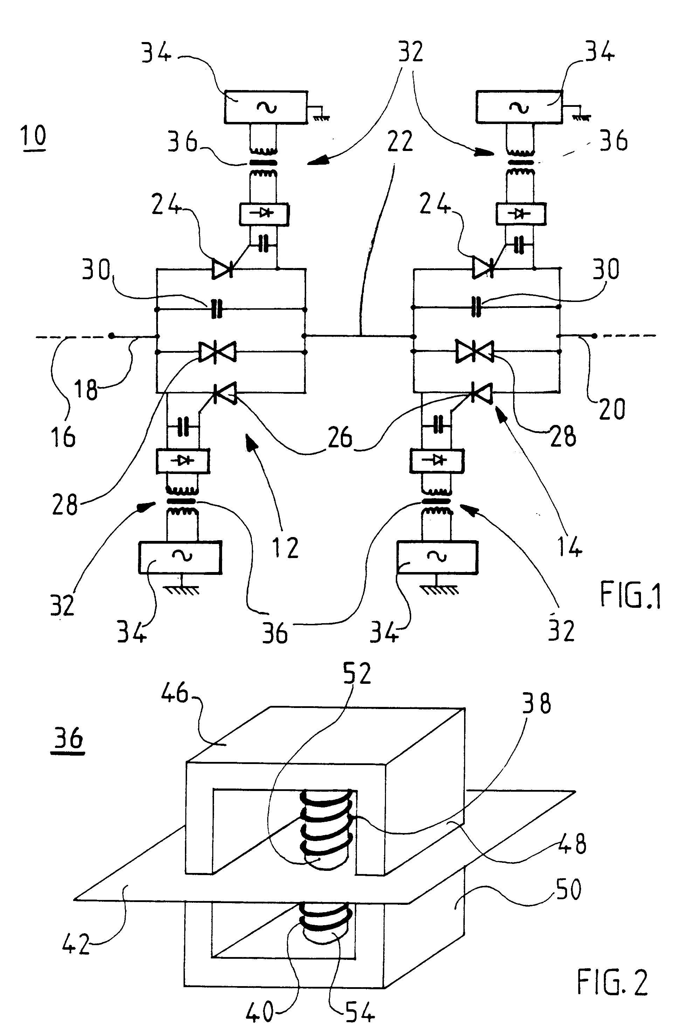

Sur la figure 1, un contacteur statique 10 à thyristors pour l'alimentation d'un moteur à moyenne tension comporte deux modules 12, 14 élémentaires connectés en série dans chaque conducteur de phase 16 du réseau. Le nombre de modules par phase dépend de la tension présente entre les bornes 18, 20 de connexion lorsque le contacteur statique 10 est ouvert. La mise en série des deux modules 12, 14 élémentaires de la figure 1 correspond à une tension nominale de réseau de l'ordre de 7,2 kV. Un seul module est nécessaire pour une tension de 3,6 kV, et trois modules pour une tension supérieure à 10 kV.

Dans le conducteur de phase 16, la borne 18 d'entrée du contacteur statique 10 est branchée du côté ligne, tandis que la borne 20 de sortie est en liaison avec la charge. Dans le cas d'un moteur triphasé, chacun des deux autres conducteurs de phase (non représentés) peut comprendre le même nombre de modules que ceux insérés dans le conducteur 16 de la figure 1. Les deux modules 12, 14 de chaque phase sont reliés entre eux par une liaison électrique 22 intermédiaire assurant la mise en série.

Chaque module 12, 14 est équipé de deux thyristors 24, 26 de puissance branchés en parallèle tête-bêche et montés sur des blocs radiateurs. Un limiteur de surtension 28 est connecté en parallèle sur les thyristors 24, 26 pour écrêter les surtensions transitoires susceptibles d'endommager les thyristors 24, 26. Un condensateur 30 est également branché en parallèle aux bornes des thyristors 24, 26, et présente une capacité prédéterminée pour contrôler la montée en tension des thyristors après passage à zéro du courant, engendrant le blocage des thyristors 24, 26, et l'ouverture du contacteur statique 10.

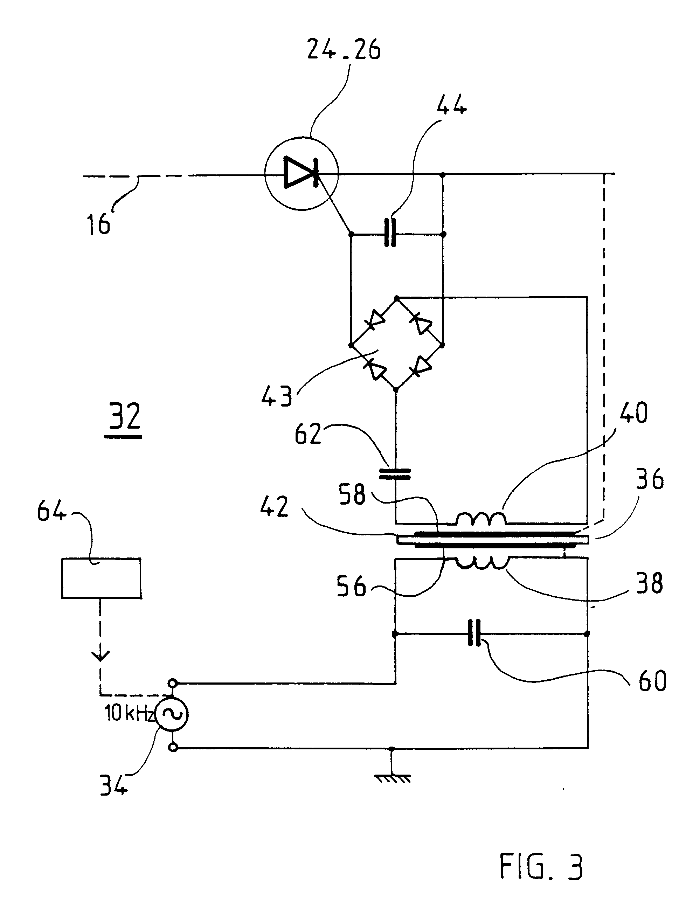

La gâchette de chaque thyristors 24, 26 des modules 12, 14 est associée à un dispositif individuel de commande 32, piloté par une source d'alimentation 34 extérieure à courant alternatif. Le dispositif de commande 32 de chaque thyristor 24, 26 est représenté en détail à la figure 3, et comporte un transformateur 36 à isolement galvanique dans lequel l'enroulement primaire 38 et l'enroulement secondaire 40 sont séparés l'un de l'autre par une plaque diélectique 42 ayant une épaisseur prédéterminée pour la tension d'isolement requise. L'enroulement primaire 38 est connecté à la source d'alimentation 34 susceptible de délivrer un courant alternatif d'excitation à haute fréquence, par exemple 10 kHZ. Cette fréquence est supérieure à celle de 50 Hz du réseau. L'une des bornes de la source d'alimentation 34 ou de l'enroulement primaire 38 est reliée à la masse. L'enroulement secondaire 40 est branché à un dispositif redresseur 43 à pont de diodes coopérant avec un condensateur 44 de filtrage connecté en parallèle entre la gâchette et la cathode du thyristor 24, 26.

Sur la figure 2, le transformateur 36 à isolement galvanique comprend un circuit magnétique 46 en ferrite ou en alliage ferromagnétique, ayant deux culasses 48, 50 en U et deux branches 52, 54 centrales disposées en regard l'une de l'autre avec interposition de la plaque diélectrique 42. L'enroulement primaire 38 est bobiné sur la première branche 52 centrale s'étendant entre la culasse 48 supérieure et la plaque diélectrique 42. L'enroulement secondaire 40 est enroulé sur la deuxième branche 54 centrale disposée entre la culasse inférieure 50 et la plaque 42, dans l'alignement avec la première branche 52. L'entrefer entre les culasses 48, 50 du transformateur 36 dépend de l'épaisseur de la plaque diélectrique 42.

La plaque diélectrique 42 est réalisée à titre d'exemple en résine époxyde, et présente une épaisseur de 1,5 mm de manière à assurer la tenue diélectrique pour une tension nominale de 7,2 kV, et une tension de choc de 31 kV. Un revêtement conducteur 56, 58 (voir figure 3) est avantageusement déposé par métallisation sous forme de film sur chaque face de la plaque 42 diélectrique pour assurer une répartition uniforme du champ électrique sur le diélectrique. Le revêtement 56 du côté primaire peut être relié au potentiel de la masse, tandis que le revêtement 58 est relié au potentiel de la cathode du thyristor. Le film conducteur est agencé en peigne de manière à éviter la présence d'un enroulement tertiaire due au film lui-même, et à une inductance parasite.

Le transfert du signal de commande vers le thyristor reste néanmoins limité par les inductances de fuite du transformateur 36. La compensation de ces inductances de fuite s'effectue au moyen d'un premier condensateur 60 disposé en parallèle sur l'enroulement primaire 38, et un deuxième condensateur 62 inséré en série entre l'enroulement secondaire 40 et le dispositif redresseur 43. La capacité de ces condensateurs 60, 62 est choisie pour accorder l'ensemble du circuit à la fréquence de 10 kHz de la source d'alimentation 34.

La source d'alimentation 34 coopère avec un circuit logique 64 de contrôle de l'ouverture et de fermeture du contacteur statique 10. Sur la figure 1, la source d'alimentation 34 est propre à chaque dispositif de commande 32, mais il est possible d'utiliser une source d'alimentation 34 commune alimentant les quatre transformateurs 36 par l'intermédiaire d'un multiplexeur.

Le fonctionnement du contacteur statique 10 selon les figures 1 à 3 est le suivant:
Dans chaque module 12, 14 le dispositif de commande 32 individuel pilote l'amorçage et le blocage de chaque thyristor 24, 26 sur ordre du circuit logique 64.

En cas de confirmation de l'amorçage lors de la fermeture du contacteur 10, le courant alternatif de 10 kHz de la source d'alimentation 34 extérieure attaque l'enroulement primaire du transformateur 36. Le courant secondaire est ensuite redressé par le dispositif redresseur 43 et lissé par le condensateur 44 de filtrage, avant de traverser le circuit gâchette et cathode du thyristor correspondant. Il en résulte un courant continu de commande qui est injecté en permanence dans la gâchette tant que le thyristor 24, 26 doit rester dans l'état passant. Au passage à zéro du courant alternatif circulant dans le conducteur de phase 16 du réseau, les thyristors 24, 26 des deux modules 12, 14 sont maintenus conducteurs grâce à la présence permanente du courant continu délivré par dispositifs de commande 32. La commande des thyristors 24, 26 ne nécessite aucune synchronisation. Dans l'état passant des thyristors 24, 26, la tension aux bornes 18, 20 des deux modules 12, 14 en série est voisine de zéro.

L'isolement phase-masse entre la ligne 16 sous tension du réseau et la masse des dispositifs de commande 32 est garanti au niveau de chaque thyristor 24, 26 par les caractéristiques du transformateur 36 correspondant (tension de choc de 31 kV, et faible capacité parasite).

L'ordre d'ouverture du contacteur statique 10 est transmis par le circuit logique 64 pour la mise hors service de la source d'alimentation 34. Les dispositifs de commande 32 des thyristors 24, 26 des deux modules 12, 14 ne sont plus alimentés, ce qui provoque le blocage automatique des thyristors 24, 26 au premier passage à zéro du courant de ligne parcourant le conducteur de phase 16.

La commande des thyristors du contacteur statique 10 s'opère pour le transfert sans synchronisation d'un signal de commande permanent de l'ordre de 1 W par thyristor 24, 26, tout en assurant un isolement important entre la ligne du réseau à moyenne tension et la source de commande.

Sur la figure 1, chaque thyristor 24, 26 de chaque module 12, 14 possède son transformateur 36 d'isolement intégré dans un dispositif de commande 32 individuel. Lorsque les quatre thyristors 22, 24 sont bloqués lors de l'ouverture du contacteur 10, une tension importante est appliquée aux bornes 18, 20 du contacteur 10. Dans le cas d'un réseau triphasé à 7,2 kV, la valeur de cette tension est de l'ordre de 7,2 kV divisé par le facteur √3. La moitié de cette valeur est appliquée aux thyristors 24, 26 tête-bêche de chaque module 12, 14.

On remarque que le potentiel de la liaison intermédiaire 22 est commun pour les deux dispositifs de commande 32 associés aux thyristors 24 et 26 respectifs des modules 12 et 14. Pour ces deux thyristors, un seul transformateur 36 d'isolement avec par exemple deux enroulements secondaires, pourrait être utilisé.

La structure circuit magnétique 46 du transformateur 36 peut être différente de celle de la figure 2, et le nombre de modules de thyristors tête-bêche connectés en série, dépend de la valeur de la tension du réseau, lequel peut être monophasé ou triphasé.

A la place du contacteur 10, le dispositif statique peut bien entendu être constitué par un gradateur ou un disjoncteur. Pour le gradateur, il suffit d'adapter la logique de commande. Pour l'application du disjoncteur, les modules 12,14 sont mis en série avec une self.

## Revendications

1. Dispositif statique pour un réseau alternatif à moyenne tension, notamment un contacteur, un disjoncteur ou un gradateur, comprenant dans chaque conducteur de phase (16), un module (12, 14) élémentaire ayant deux thyristors (24, 26) de puissance branchés en parallèle tête-bêche, et un dispositif d'amorçage pour le passage de l'état bloqué vers l'état conducteur des thyristors (24, 26) respectivement lors de l'ouverture et de la fermeture du dispositif (10), la gâchette de chaque thyristor (24), (26) étant associée à un dispositif individuel de commande (32) comportant un transformateur (36) possédant un enroulement primaire (38) connecté à une source d'alimentation (34) extérieure à courant alternatif ayant une fréquence supérieure à celle du réseau, et un enroulement secondaire (40) coopérant avec un dispositif redresseur (43) pour injecter en permanence un courant de commande dans ladite gâchette tant que le thyristor (24, 26) correspondant doit rester dans l'état conducteur, caractérisé en ce que la source d'alimentation (34) se trouve au potentiel de la masse, et qu'une plaque diélectrique (42) est interposée entre l'enroulement primaire (38) et l'enroulement secondaire (40) du transformateur (36) à isolement galvanique, ladite plaque en matériau isolant ayant une épaisseur prédéterminée pour la tension d'isolement requise entre le conducteur de phase (16) du réseau et la source d'alimentation (34), et des moyens (56,58) de répartition uniforme du champ électrique sur la plaque (42) diélectrique.

2. Dispositif statique selon la revendication 1, caractérisé en ce que le courant de commande du thyristor (24, 26) est un courant continu obtenu au moyen d'un condensateur de filtrage (44) disposé à la sortie du dispositif redresseur (43), en parallèle entre la gâchette et la cathode du thyristor (24, 26).

3. Dispositif statique selon l'une des revendications 1 ou 2, caractérisé en ce que la source d'alimentation (34) est pilotée par une circuit logique (64) de contrôle pour l'établissement ou l'interruption du courant de commande dans la gâchette des thyristors (24, 26) du module (12, 14) provoquant respectivement le déblocage des thyristors lors de la fermeture du dispositif, et le blocage automatique des thyristors (24, 26) intervenant lors de l'ouverture du dispositif au premier passage à zéro du courant de ligne parcourant le conducteur de phase (16).

4. Dispositif statique selon l'une des revendications 1 à 3, caractérisé en ce que le transformateur (36) est associé à des condensateurs (60, 62) raccordé du côté primaire et/ou secondaire pour compenser les inductances de fuite, l'ensemble étant accordé à la fréquence de la source d'alimentation (34).

5. Dispositif statique selon l'une des revendications 1 à 4, caractérisé en ce que le transformateur (36) de chaque dispositif de commande (32) est équipé d'un circuit magnétique (46) en ferrite ou en alliage ferromagnétique, ayant deux culasses (48, 50) en U et deux branches (52, 54) centrales disposées respectivement en regard l'une de l'autre avec interposition d'un entrefer défini par l'épaisseur de la plaque diélectrique (42), l'enroulement primaire (38) étant bobiné sur la première branche (52) centrale s'étendant entre l'une des culasses (48) et la plaque diélectrique (42), et l'enroulement secondaire (40) étant enroulé sur la deuxième branche (54) centrale disposée entre l'autre culasse (50) et la plaque diélectrique (42) dans l'alignement avec la première branche (52).

6. Dispositif statique selon la revendication 1 ou 5, caractérisé en ce que les moyens (56,58) de répartition du champ électrique comportent un film conducteur agencé sur chaque face de la plaque (42), l'un (56) des revêtements étant relié au potentiel de la masse, et l'autre (58) au potentiel du conducteur (16) de phase.

7. Dispositif statique selon la revendication 6, caractérisé en ce que chaque film conducteur (56, 58) est conformé en peigne.

8. Dispositif statique selon l'une des revendications 1 à 7, caractérisé en ce qu'une pluralité de modules (12, 14) élémentaires de thyristors tête-bêche (24, 26) peuvent être connectés en série dans le conducteur de phase (16) en fonction de la valeur de la tension du réseau.

9. Dispositif statique selon l'une des revendications 1 à 8, caractérisé en ce que chaque module (12, 14) comporte un limiteur de surtension (28) et un condensateur (30) branchés chacun en parallèle aux bornes des thyristors (24, 26), respectivement pour écrêter les surtensions transitoires, et pour contrôler la montée en tension des thyristors lors de l'ouverture du dispositif statique.

## Claims

1. A static device for a medium voltage A.C. mains system, notably a contactor, circuit breaker or graduator, comprising in each phase conductor (16), an elementary module (12, 14) having two power thyristors (24, 26) connected in parallel head-to-tail, and a triggering device for switching the thyristors (24, 26) from the off state to the on state respectively when the device (10) opens and closes, the trigger of each thyristor (24, 26) being associated with an individual control device (32) comprising a transformer (36) having a primary winding (38) connected to an external A.C. power source (34) having a higher frequency than that of the mains system, and a secondary winding (40) cooperating with a rectifier device (43) to continuously input a control current to said trigger so long as the corresponding thyristor (24, 26) has to remain in the on state, characterized in that the power source (34) is at ground potential, and that a dielectric plate (42) is interposed between the primary winding (38) and secondary winding (40) of the galvanic isolation transformer (36), said plate made of insulating material having a predetermined thickness for the isolation voltage required between the mains system phase conductor (16) and the power source (34), and means (56, 58) for distributing the electrical field uniformally over the dielectric plate (42).

2. The static device according to claim 1, characterized in that the control current of the thyristor (24, 26) is a D.C. current obtained by means of a filtering capacitor (44) connected to the output of the rectifier device (43), in parallel between the trigger and cathode of the thyristor (24, 26).

3. The static device according to claim 1 or 2, characterized in that the power source (34) is controlled by a logic control circuit (64) for making or breaking of the control current in the trigger of the thyristors (24, 26) of the module (12, 14) resulting respectively in turn-on of the thyristors when the device closes, and automatic turn-off of the thyristors (24, 26) taking place when the device opens the first time the line current flowing in the phase conductor (16) reaches zero.

4. The static device according to one of the claims 1 to 3, characterized in that the transformer (36) is associated with capacitors (60, 62) connected on the primary and/or secondary side to compensate leakage inductances, the assembly being tuned to the frequency of the power source (34).

5. The static device according to one of the claims 1 to 4, characterized in that the transformer (36) of each control device (32) is equipped with a magnetic circuit (46) made of ferrite or ferromagnetic alloy, having two U-shaped shells (48, 50) and two central branches (52, 54) arranged respectively facing one another with interposition of an air-gap defined by the thickness of the dielectric plate (42), the primary winding (38) being wound onto the first central branch (52) extending between one of the shells (48) and the dielectric plate (42), and the secondary winding (40) being wound onto the second central branch (54) arranged between the other shell (50) and the dielectric plate (42) in alignment with the first branch (52).

6. The static device according to claim 1 or 5, characterized in that the means (56, 58) for distributing the electrical field comprise a conducting film arranged on each face of the plate (42), one (56) of the coatings being connected to the ground potential, and the other (58) to the potential of the phase conductor (16).

7. The static device according to claim 6, characterized in that each conducting film (56, 58) is shaped as a comb.

8. The static device according to one of the claims 1 to 7, characterized in that a plurality of elementary modules (12, 14) of head-to-tail thyristors (24, 26) can be serially connected in the phase conductor (16) according to the value of the mains system voltage.

9. The static device according to one of the claims 1 to 8, characterized in that each module (12, 14) comprises a surge limiter (28) and a capacitor (30) each connected in parallel to the terminals of the thyristors (24, 26), respectively to clip the transient voltage surges, and to control the voltage rise of the thyristors when the static device opens.

## Patentansprüche

1. Elektronische Schaltung für ein Mittelspannungs-Wechselstromnetz, insbesondere ein Schütz, Leistungsschalter oder Dimmer, die in jedem Phasenleiter (16) ein Grundmodul (12, 14) mit zwei antiparallel geschalteten Leistungs-Thyristoren (24, 26) sowie eine Zündschaltung aufweist, um bei Aus- bzw. Einschaltung der elektronischen Schaltung (10) die Umschaltung der Thyristoren (24, 26) vom gesperrten in den leitenden Zustand zu bewirken, wobei dem Gateanschluß jedes Thyristors (24, 26) eine eigene Ansteuerungsschaltung (32) mit einem Transformator (36) zugeordnet ist, dessen Primärwicklung (38) an eine externe Wechselspannungsquelle (34) mit einer über der Netzfrequenz liegenden Frequenz angeschlossen ist, und dessen Sekundärwicklung (40) mit einer Gleichrichterschaltung (43) zusammenwirkt, derart daß der genannte Gateanschluß ununterbrochen mit einem Steuerstrom beaufschlagt wird, solange der leitende Zustand des entsprechenden Thyristors (24, 26) aufrechterhalten werden muß, dadurch gekennzeichnet, daß die Steuerspannungsquelle (34) auf Massepotential liegt und daß zwischen der Primärwicklung (38) und der Sekundärwicklung (40) des Trenntransformators (36) eine dielektrische Abschirmung (42) eingefügt ist, wobei die als Isolierstoffplatte ausgeführte Abschirmung eine Dicke entsprechend der eforderlichen Isolationsspaunung zwischen dem Phasenleiter (16) des Netzes und der Steuerspannungsquelle (34) sowie Mittel (56, 58) zur gleichmäßigen Verteilung des elektrischen Felds auf der Isolierstoffplatte (42) aufweist.

2. Elektronische Schaltung nach Anspruch 1, dadurch gekennzeichnet, daß der Steuerstrom des Thyristors (24, 26) ein Gleichstrom ist, der von einem Glättungskondensator (44) abgenommen wird, der im Ausgangskreis der zwischen Gateanschluß und Kathode des Thyristors (24, 26) parallelgeschalteten Gleichrichterschaltung (43) liegt.

3. Elektronische Schaltung nach Anspruch 1 oder 2, dadurch gekennzeichnet, daß die Spannungsquelle (34) durch eine Steuerlogik (64) angesteuert wird, so daß der Steuerstrom am Gateanschluß der Thyristoren (24, 26) des Moduls (12, 14) bereitgestellt oder unterbrochen wird und so das Durchschalten der Thyristoren beim Einschalten des Schützes bzw. das während des ersten Nulldurchgangs des Stroms im Phasenleiter (16) automatisch erfolgende Sperren der Thyristoren bei Abschaltung des Schützes bewirkt wird.

4. Elektronische Schaltung nach einem der Ansprüche 1 bis 3, dadurch gekennzeichnet, daß der Transformator (36) zur Kompensation der Streuinduktivitäten mit primär- und/oder sekundärseitig angeschlossenen Kondensatoren (60, 62) verbunden ist, wobei die gesamte Schaltungseinheit auf die Frequenz der Steuerspannungsquelle (34) abgestimmt ist.

5. Elektronische Schaltung nach einem der Ansprüche 1 bis 4, dadurch gekennzeichnet, daß der Trenntransformator (36) jeder Ansteuerungsschaltung (32) einen aus Ferrit oder einer ferromagnetischen Legierung bestehenden magnetischen Kreis (46) aufweist, der sich aus zwei U-förmigen Jochen (48, 50) sowie zwei sich gegenüberliegenden Mittelschenkeln (52, 54) zusammensetzt, zwischen denen ein Luftspalt besteht, dessen Breite durch die Dicke der Isolierstoffplatte (42) bestimmt wird, wobei die Primärwicklung (38) um den ersten, zwischen dem oberen Joch (48) und der Isolierstoffplatte (42) angeordneten Mittelschenkel (52) und die Sekundärwicklung (40) um den zweiten, zwischen dem unteren Joch (50) und der Isolierstoffplatte (42) in einer Flucht mit dem oberen Schenkel (52) angeordneten Mittelschenkel (54) gewickelt ist.

6. Elektronische Schaltung nach einem der Ansprüche 1 bis 5, dadurch gekennzeichnet, daß die Mittel (56, 58) zur Verteilung des elektrischen Feldes einen auf jeder Seite der Isolierstoffplatte (42) aufgebrachten leitenden Film umfassen, wobei die eine Beschichtung (56) an Masse und die andere Beschichtung (58) am Potential des Phasenleiters (16) liegt.

7. Elektronische Schaltung nach Anspruch 6, dadurch gekennzeichnet, daß jeder leitende Film (56, 58) kammförmig ausgefürht ist.

8. Elektronische Schaltung nach einem der Ansprüche 1 bis 7, dadurch gekennzeichnet, daß in Abhängigkeit vom Wert der Netzspannung mehrere Grundmodule (12, 14) mit antiparallel geschalteten Thyristoren (24, 26) in Reihe in den Phasenleiter (16) geschaltet werden können.

9. Elektronische Schaltung nach einem der Ansprüche 1 bis 8, dadurch gekennzeichnet, daß jedes Modul (12, 14) mit einem Überspannungsbegrenzer (28) und einem Kondensator (30) bestückt ist, die jeweils parallel zu den Klemmen des Thyristors (24, 26) geschaltet sind, um kurzzeitige Überspannungen zu begrenzen bzw. den Spannungsanstieg an den Thyristoren bei Abschaltung der elektronischen Schaltung zu steuern.
